# EUROPÄISCHE PATENTSCHRIFT

(11) **EP 2 625 939 B1**
(45) Veröffentlichungstag und Bekanntmachung des Hinweises auf die Patenterteilung: **25.01.2017**
(21) Anmeldenummer: 11773392.3
(22) Anmeldetag: 06.10.2011
(51) Int. Cl.: H05K 7/14, G05B 19/00

(54) **VERFAHREN UND BEDIENEINHEIT ZUM BEDIENEN VON MODULEN DER AUTOMATISIERUNGSTECHNIK**
METHOD AND OPERATING UNIT FOR OPERATING MODULES IN AUTOMATION TECHNOLOGY
PROCÉDÉ ET UNITÉ DE COMMANDE POUR ACTIONNER DES MODULES RELEVANT DE LA TECHNIQUE D'AUTOMATISATION

(30) Priorität: 07.10.2010 DE 102010047632
(43) Veröffentlichungstag der Anmeldung: 14.08.2013
(73) Patentinhaber: Phoenix Contact GmbH & Co. KG, 32825 Blomberg (DE)
(72) Erfinder: FELDMANN, Jürgen, 32825 Blomberg (DE); HIRSCH, Thomas, 32578 Detmold (DE); GRIES, Simon-Immanuel, 32760 Detmold (DE)
(74) Vertreter: Blumbach Zinngrebe
(86) Internationale Anmeldenummer: PCT/EP2011/004978
(87) Internationale Veröffentlichungsnummer: WO 2012/045453

(56) Entgegenhaltungen:
- EP-A2- 2 182 418
- DE-U1-202008 015 406
- US-A1- 2003 084 211
- US-A1- 2010 236 824

## Beschreibung

Die Erfindung betrifft ein Verfahren und eine Vorrichtung zum Bedienen eines insbesondere als Gerät eines Automatisierungssystems ausgebildeten Moduls mit einer modulseitigen Kommunikationsschnittstelle.

In der industriellen Automatisierungstechnik werden eine Vielzahl unterschiedlicher Module, beispielsweise zur Messund Regelungstechnik, eingesetzt. Bedieneinheiten für solche Module werden typischerweise für ein bestimmtes Modul oder eine eingeschränkte Gruppe von Modulen entwickelt, d.h. die zu dem jeweiligen Modul gehörige Menüstruktur und -funktionalität einer Bedienapplikation wird fest in den jeweiligen Bedieneinheiten vorgehalten. Somit ist eine Nutzung der Bedieneinheit für zukünftig neu entwickelte Module nicht möglich, sondern es muss vielmehr jeweils auch die Bedieneinheit neu entwickelt werden, wodurch ein hoher Entwicklungsaufwand entsteht.

Aus US 2003/0084211 A1 ist beispielsweise bekannt, ein I/O-Gerät mit einer Benutzerschnittstelle auszurüsten, um einem Techniker zu ermöglichen, ohne zusätzliche Hilfsmittel auf das I/O-Gerät zuzugreifen. Aus EP 2 182 418 A2 ist ferner ein Verfahren und eine Vorrichtung zum Zugreifen auf ein Funktionsmodul eines Automatisierungssystems bekannt, wobei das Funktionsmodul als Teil eines unterlagerten Geräts und zum Ausführen einer Gerätefunktion ausgebildet ist.

In der industriellen Automatisierungstechnik eingesetzte Module der Mess- und Regelungstechnik können beispielsweise Sensoren, Aktoren, Überwachungsbausteine, Messumformer oder einen anderen von einer Vielzahl unterschiedlicher Bausteine umfassen. Zum Konfigurieren und/oder Parametrieren eines Moduls weist dieses typischerweise eine nach außen geführte Kommunikationsschnittstelle auf, an welche wahlweise eine abnehmbare Bedieneinheit oder ein Personalcomputer (PC) angeschlossen werden können. Wenn vom PC auf das Modul zugegriffen werden soll, muss in nachteiliger Weise die Bedieneinheit von dem Modul entfernt werden, um den PC an die Kommunikationsschnittstelle anschließen zu können.

Aus US 2010/236824 A1 ist ein Gebäude-Automatisierungssystem bekannt, welches eine Wand-Box und eine auf dieser Wand-Box montierbare Kontrolleinheit umfasst, wobei die Kontrolleinheit einen Mikrocontroller und gespeicherte Steueranweisungen zum Steuern von Umgebungsbedingungen im Gebäude aufweist, und wobei die Wand-Box eine außerhalb der Kontrolleinheit angeordnete Konfigurations-Speichereinheit aufweist, in welcher Konfigurationsdaten zum Konfigurieren der Kontrolleinheit gespeichert sind.

In DE 20 2008 015406 U1 wird ferner ein transportabler Datenträger zum Übertragen von Konfigurationsdaten von einem externen Rechner auf einen Sensor beschrieben, wobei der Datenträger ein erstes Anschlussmittel zum Verbinden des Datenträgers mit dem externen Rechner und ein zweites Anschlussmittel zum Verbinden des Datenträgers mit dem Sensor umfasst.

Der Erfindung liegt die Aufgabe zugrunde, einen neuen und/oder verbesserten Weg zum Bedienen eines insbesondere als Gerät eines Automatisierungssystems ausgebildeten Moduls mit einer modulseitigen Kommunikationsschnittstelle aufzuzeigen.

Die Aufgabe wird durch eine Bedieneinheit gemäß Anspruch 1 und durch ein Verfahren gemäß Anspruch 9 gelöst. Vorteilhafte Ausführungsformen und Weiterbildungen sind in den jeweiligen Unteransprüchen angegeben.

Dementsprechend sieht die Erfindung eine Bedieneinheit zum Bedienen eines Moduls mit einer modulseitigen Kommunikationsschnittstelle vor, welche Befestigungsmittel zum lösbaren Befestigen der Bedieneinheit an dem Modul aufweist, sowie Eingabe- und Ausgabemittel zum Eingeben und Ausgeben von Informationen. Ferner weist die Bedieneinheit eine erste und eine zweite Kommunikationsschnittstelle auf, wobei die erste Kommunikationsschnittstelle bei befestigter Bedieneinheit mit der modulseitigen Kommunikationsschnittstelle verbunden und zum Datenaustausch zwischen Bedieneinheit und Modul ausgebildet ist, und wobei die zweite Kommunikationsschnittstelle zur Kommunikation mit einem separaten Bediengerät dient.

Bei dem Modul handelt es sich insbesondere um ein Gerät eines Automatisierungssystems, wobei das Modul vorteilhaft als Gerät der Mess-, Steuer- und Regelungstechnik oder als Konverter für die Mess-, Steuer- und Regelungstechnik ausgebildet ist. Das Bedienen des Moduls umfasst dementsprechend vorteilhaft das Anzeigen und/oder Ändern von Parametrierungs- und/oder Konfigurationsdaten und/oder das Anzeigen von Prozesswerten.

Ein Konverter für die Mess-, Steuer- und Regelungstechnik dient insbesondere dazu, die Verfälschung analoger Signale durch externe Störgrößen zu vermeiden, da die Übertragung analoger Signale in industriellen Umgebungen besonders störanfällig ist. Durch eine exakte Umsetzung, Trennung oder Anpassung analoger Signale sichert und erhöht ein Konverter die Übertragungsqualität und damit die Güte von Regelkreisen.

Dementsprechend kann das Modul beispielsweise als Signaltrenner zur galvanischen Trennung, Verstärkung, Filterung und/oder Anpassung analoger Signale, als Messumformer zur Umsetzung von Signalgrößen oder als Überwachungsbaustein zur Erfassung analoger Signale und zur Steuerung und Überwachung einer Funktion in Abhängigkeit des Signalwertes ausgebildet sein.

Ein Kerngedanke der Erfindung besteht darin, mittels der zweiten Kommunikationsschnittstelle der Bedieneinheit eine Möglichkeit zu schaffen, einen Computer mit dem Modul zu verbinden, wenn bereits eine Bedieneinheit an dem Modul befestigt ist und dementsprechend die erste Kommunikationsschnittstelle der Bedieneinheit an die modulseitige Kommunikationsschnittstelle angeschlossen ist. Dementsprechend ist die Bedieneinheit vorteilhaft zur Steuerung einer Kommunikation zwischen einem an der ersten Kommunikationsschnittstelle angeschlossenen Modul und einem an der zweiten Kommunikationsschnittstelle angeschlossenen separaten Bediengerät ausgebildet, wobei das separate Bediengerät insbesondere ein PC ist, welcher beispielsweise als Laptop oder Tablet PC ausgebildet sein kann.

Zu diesem Zweck ist in einer vorteilhaften Ausführungsform vorgesehen, dass der modulseitigen Kommunikationsschnittstelle des angeschlossenen Moduls eine erste Adresse und der zweiten Kommunikationsschnittstelle der Bedieneinheit eine zweite, von der ersten unterschiedliche, Adresse zugeordnet sind. In dieser Ausführungsform ist die Bedieneinheit dazu ausgebildet, von dem separaten Bediengerät empfangene Datentelegramme, welche die erste Adresse umfassen, an das Modul weiterzuleiten, sowie die Antwort des Moduls an das separate Bediengerät weiterzuleiten. Vorzugsweise umfasst die Bedieneinheit einen Master-Protokoll-Stack zur Kommunikation mit dem Modul und einen Slave-Protokoll-Stack zur Kommunikation mit dem separaten Bediengerät.

Ein weiterer Kerngedanke der Erfindung besteht darin, dass die Bedieneinheit unterschiedliche, insbesondere auch zukünftige Module unterstützt. Dies wird dadurch erreicht, dass sich der verwendete Mikrocontroller der Bedieneinheit zur Laufzeit selbst programmieren kann. Wenn ein Modul anderen Typs an die Bedieneinheit angeschlossen wird, so lädt die Bedieneinheit besonders vorteilhaft die zu dem Modul zugehörige Menüstruktur und -funktionalität in Form eines Applikationsteils aus dem Modul und ersetzt damit einen Teil ihres eigenen Speichers, wobei zweckmäßigerweise als Speicher ein Flash-Speicher verwendet wird und der Applikationsteil in Form von ausführbarem Hex-Code geladen wird.

Dementsprechend ist das Befestigungsmittel zum Befestigen der Bedieneinheit an Modulen unterschiedlicher Modultypen ausgebildet. Ferner ist die Bedieneinheit dazu ausgebildet, von einem an der ersten Kommunikationsschnittstelle angeschlossenen Modul eine Identifikationsinformation, welche einen Modultyp identifiziert, zu empfangen und zu speichern.

Die Bedieneinheit umfasst wenigstens einen Speicher zum Speichern einer Bedienapplikation, wobei der Speicher einen ersten Speicherbereich zum Speichern eines ersten Applikationsteils und einen zweiten Speicherbereich zum Speichern eines zweiten Applikationsteils umfasst, wobei Zugriffe zwischen den Applikationsteilen über eine vorgegebene Software-Schnittstelle der Bedieneinheit gesteuert werden. Bei dem zweiten Applikationsteil handelt es sich um den modulspezifischen Applikationsteil, welcher von einem angeschlossenen Modul geladen wird.

Die Bedienapplikation stellt besonders vorteilhaft eine Bedienschnittstelle bereit, welche eine grafische Benutzerschnittstelle umfasst, mittels der einem Benutzer ein Menü zur Auswahl ausführbarer Funktionen angezeigt wird. Der modulspezifische Menübereich, welcher die modulspezifische Menüstruktur und die modulspezifischen Funktionen umfasst, wird durch den zweiten Applikationsteil bereitgestellt.

Die Bedieneinheit ist dazu ausgebildet, vor Herunterladen des zweiten Applikationsteils die Identifikationsinformation von dem angeschlossenen Modul zu empfangen und mit der zuletzt gespeicherten Identifikationsinformation zu vergleichen, und nur wenn sich die empfangene und die zuletzt gespeicherte Identifikationsinformation unterscheiden, den zweiten Applikationsteil von dem angeschlossenen Modul zu laden und die empfangene Identifikationsinformation zu speichern. Auf diese Weise wird nur dann ein zweiter Applikationsteil vom Modul geladen, wenn dies erforderlich ist.

Als Speicher ist vorzugsweise ein RAM- und/oder ein FlashSpeicher vorgesehen, wobei vorzugsweise sowohl der erste als auch der zweite Speicherbereich jeweils einen RAM-Speicher und einen Flash-Speicher umfassen.

In einer bevorzugten Ausführungsform sind die erste und zweite Kommunikationsschnittstelle der Bedieneinheit für eine serielle Datenübertragung ausgebildet.

Ein erfindungsgemäßes Verfahren zum Bedienen eines insbesondere als Gerät eines Automatisierungssystems ausgebildeten Moduls mit einer modulseitigen Kommunikationsschnittstelle sieht vor, an dem Modul eine Bedieneinheit wie oben beschrieben zu befestigen, so dass die erste Kommunikationsschnittstelle der Bedieneinheit mit der modulseitigen Kommunikationsschnittstelle verbunden ist, und mittels einer in einem Speicher der Bedieneinheit hinterlegten Bedienapplikation eine Benutzerschnittstelle bereitzustellen.

Das Verfahren umfasst das Übertragen einer Identifikationsinformation, welche einen Modultyp identifiziert, von dem Modul zu der Bedieneinheit und das Vergleichen der empfangenen Identifikationsinformation mit einer an einem vorgegebenen Speicherort in der Bedieneinheit hinterlegten Identifikationsinformation durch die Bedieneinheit. Wenn sich die empfangene Identifikationsinformation von der hinterlegten Identifikationsinformation unterscheidet, lädt die Bedieneinheit den zweiten Applikationsteil von dem Modul, speichert den heruntergeladenen zweiten Applikationsteil in einem zweiten Speicherbereich der Bedieneinheit, wobei der zweite Applikationsteil und ein erster, in einem ersten Speicherbereich der Bedieneinheit hinterlegter erster Applikationsteil die Bedienapplikation bilden, und speichert die empfangene Identifikationsinformation an dem vorgegebenen Speicherort in der Bedieneinheit. Nach Vergleichen der Identifikationsinformationen und gegebenenfalls Herunterladen und Speichern des zweiten Applikationsteils sowie Speichern der empfangenen Identifikationsinformation führt die Bedieneinheit die Bedienapplikation aus, wobei Zugriffe zwischen dem ersten und zweiten Applikationsteil über eine vorgegebene Software-Schnittstelle erfolgen.

In einer vorteilhaften Ausführungsform wird der modulseitigen Kommunikationsschnittstelle des Moduls eine erste Adresse und der zweiten Kommunikationsschnittstelle der Bedieneinheit eine zweite, von der ersten unterschiedliche, Adresse zugeordnet, und die Bedieneinheit steuert eine Kommunikation zwischen einem an der ersten Kommunikationsschnittstelle angeschlossenen Modul und einem an der zweiten Kommunikationsschnittstelle angeschlossenen separaten Bediengerät, wobei an die erste Adresse adressierte Datentelegramme, welche die Bedieneinheit von einem an der zweiten Kommunikationsschnittstelle angeschlossenen separaten Bediengerät empfängt, an das Modul weitergeleitet werden.

Zweckmäßigerweise wird bei Empfang eines an die erste Adresse adressierten Datentelegramms von dem separaten Bediengerät und gleichzeitiger Kommunikation zwischen Bedieneinheit und Modul das Weiterleiten des von dem separaten Bediengerät empfangenen Datentelegramms an das Modul verzögert, bis die Kommunikation zwischen Bedieneinheit und Modul abgeschlossen ist. Entsprechend wird vorteilhaft bei gleichzeitiger Kommunikation zwischen separatem Bediengerät und Modul eine durch die Bedieneinheit initiierte Kommunikation zwischen Bedieneinheit und Modul verzögert, bis die Kommunikation zwischen separatem Bediengerät und Modul abgeschlossen ist.

Die Erfindung wird nachfolgend beispielhaft anhand bevorzugter Ausführungsformen und unter Bezugnahme auf die beigefügten Zeichnungen genauer beschrieben. Dabei bezeichnen gleiche Bezugszeichen in den Zeichnungen gleiche oder ähnliche Teile.

Es zeigen:
- Fig. 1:: eine schematische Darstellung einer bevorzugten Ausführungsform einer erfindungsgemäßen Bedieneinheit, welche auf ein Modul aufgerastet ist,
- Fig. 2:: schematisch die in Fig. 1 dargestellte Bedieneinheit in abgerastetem Zustand,
- Fig. 3: schematisch den Selbstprogrammierungsvorgang einer bevorzugten Ausführungsform einer erfindungsgemäßen Bedieneinheit, und
- Fig. 4: schematisch eine bevorzugte Ausführungsform einer erfindungsgemäßen Bedieneinheit, welche mit einem Modul und einem PC als separatem Bediengerät verbunden ist.

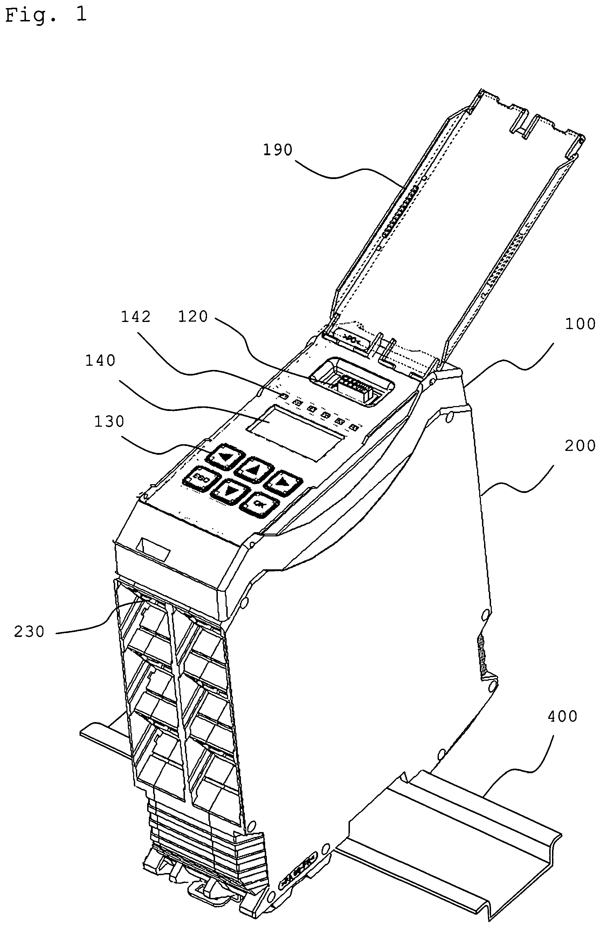

Fig. 1 zeigt ein Modul 200 der Automatisierungstechnik, welches analoge Signaleingänge 230 umfasst und beispielsweise als Sensor, Aktor oder als Überwachungsbaustein ausgebildet ist. Aufgerastet auf das Modul 200 ist eine erfindungsgemäße Bedieneinheit 100, wobei durch das Aufrasten die Bedieneinheit 100 lösbar mit dem Modul 200 verbunden ist. Im dargestellten Ausführungsbeispiel ist das Modul 200 zur Montage auf einer Hutschiene 400 ausgebildet.

Die Bedieneinheit 100 umfasst in der dargestellten Ausführungsform Eingabemittel in Form von Tastknöpfen 130, sowie Ausgabemittel in Form eines Displays 140 und LEDs 142. Ferner ist zum Schutz der Eingabe- und Ausgabemittel eine aufklappbare Abdeckung 190 vorgesehen. In der Bedieneinheit 100 ist eine Bedienapplikation hinterlegt, welche dazu ausgebildet ist, mittels der Eingabe- und Ausgabemittel eine grafische Benutzerschnittstelle bereitzustellen, wobei auf dem Display 140 bei Ausführen der Bedienapplikation ein Menü mit durch einen Benutzer auswählbaren Funktionen dargestellt wird, wobei die Auswahl mittels der Tastknöpfe 130 erfolgt.

Die Bedieneinheit 100 umfasst eine erste Kommunikationsschnittstelle 110, welche in dem dargestellten aufgerasteten Zustand mit einer modulseitigen Kommunikationsschnittstelle 210 verbunden ist, so dass eine Kommunikation zwischen Modul 200 und Bedieneinheit 100 ermöglicht wird. Die modulseitigen Kommunikationsschnittstelle 210 ist in der dargestellten Ausführungsform auf der Oberseite des Moduls 200 angeordnet und die erste Kommunikationsschnittstelle 110 der Bedieneinheit 100 ist auf deren Unterseite angeordnet. Dementsprechend sind die Schnittstellen 110 und 210 in Fig. 1 nicht sichtbar.

Die Bedieneinheit 100 weist ferner eine zweite Kommunikationsschnittstelle 120 zum Anschließen eines beispielsweise als PC ausgebildeten separaten Bediengerätes auf.

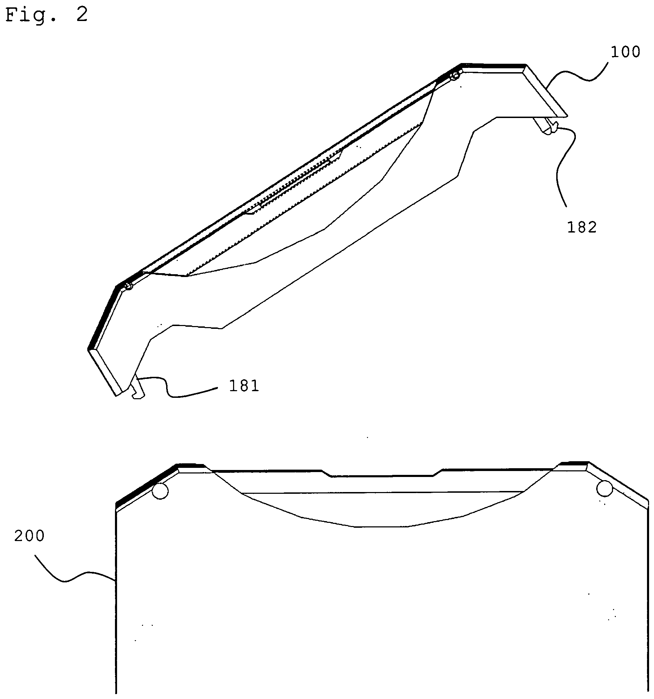

In Fig. 2 sind die Bedieneinheit 100 und das Modul 200 in ausgerasteten Zustand dargestellt. Das Einrasten der Bedieneinheit 100 in das Modul 200 erfolgt mittels Rastelementen 181 und 182, welche im eingerasteten Zustand in zugeordnete Einrastelemente des Moduls 200 einrasten. Wenigstens eines der Rastelemente 181, 182 oder ein Einrastelement des Moduls 200 ist derart beweglich angeordnet, dass ein Ausrasten durch manuelle Betätigung ermöglicht wird.

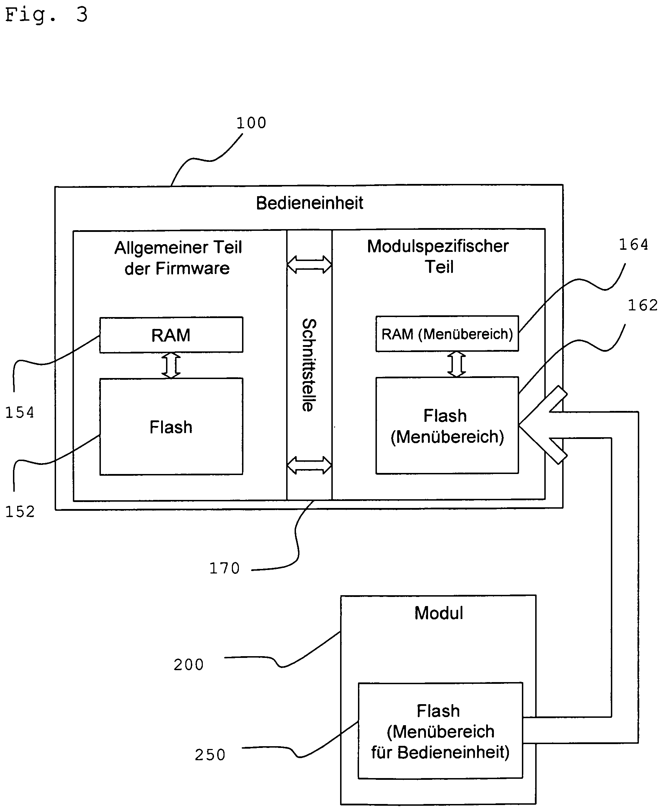

Fig. 3 zeigt schematisch den Speicheraufbau einer bevorzugten Ausführungsform einer Bedieneinheit 100 und eines daran angeschlossenen Moduls 200. Das Ausführungsbeispiel zeigt schematisch den durch einen Mikrocontroller der Bedieneinheit 100 gesteuerten Selbstprogrammierungsvorgang. Jeder Modultyp ist über eine eindeutige Identifikationsnummer (ID) zu unterscheiden. Die Bedieneinheit speichert die ID des Moduls, zu dem der aktuell geladene Menübereich gehört. Dieser Menübereich umfasst die modulspezifische Menüstruktur und die modulspezifischen Funktionen, die aus dem Menü heraus aufgerufen werden können.

Nach dem Einschalten liest die Bedieneinheit 100 als erstes die ID des angeschlossenen Moduls 200 aus und vergleicht diese mit der ID, welche zu dem aktuell geladenen Menübereich gehört. Sind diese beiden IDs unterschiedlich, wurde die Bedieneinheit 100 an ein Modul anderen Typs angeschlossen und die Bedieneinheit 100 beginnt damit, den zu diesem Modul 200 zugehörigen Menübereich, in Form von ausführbarem Hex-Code, aus dem Speicher 250 des angeschlossenen Moduls 200 zu laden und sich damit während des Betriebs selbst zu programmieren. Die eigentliche Firmware ist im Speicherbereich 152 des Flashspeichers des Mikrocontrollers gespeichert und verwendet den Speicherbereich 154 des RAM-Speichers des Mikrocontrollers.

Für den Menübereich ist ein fester Bereich 162 im Flashspeicher des Mikrocontrollers der Bedieneinheit 100 reserviert. Für statische Variablen des Menübereiches ist darüber hinaus ein fester Bereich 164 im RAM des Mikrocontrollers reserviert.

Um sowohl von Programmcode außerhalb des Menübereichs auf Funktionen und/oder Variablen innerhalb des Menübereichs als auch von Funktionen des Menübereichs auf Funktionen und/oder Variablen außerhalb des Menübereichs zugreifen zu können, ist eine definierte Schnittstelle 170 zwischen den beiden Bereichen vorgesehen. Auf diese Weise ist es möglich, den Menübereich für jedes Modul speziell anzupassen, ohne Änderungen an der eigentlichen, im Speicherbereich 152 des Flashspeichers des Mikrocontrollers gespeicherten Firmware der Bedieneinheit vornehmen zu müssen.

Für die Verwendung einer Bedieneinheit 100 in der dargestellten Ausführungsform muss nach Erstellung des Menübereiches dieser als Hex-Code im Speicher des jeweiligen Moduls abgelegt werden, damit jede Bedieneinheit sich diesen aus dem Modul laden und somit mit dem Modul zusammen betrieben werden kann.

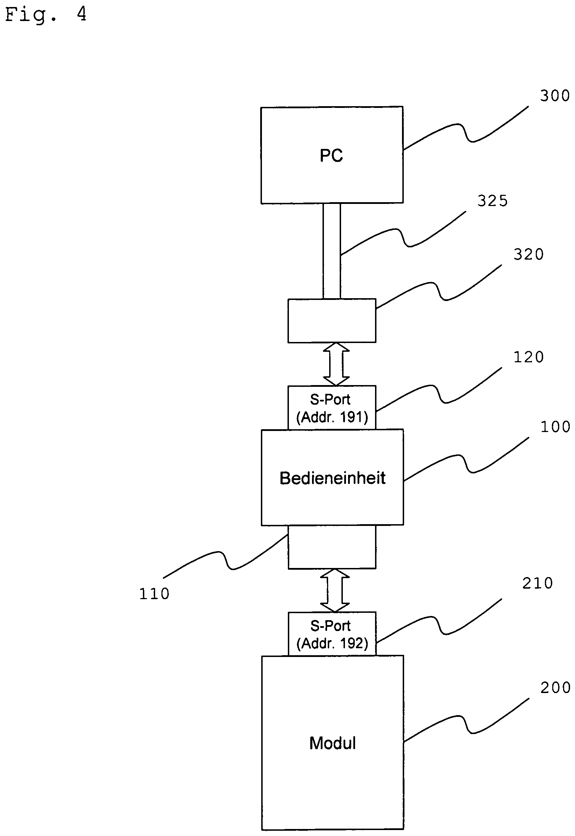

In dem in Fig. 4 dargestellten Ausführungsbeispiel ist ein PC 300 an eine Bedieneinheit 100 und diese an ein Modul 200 angeschlossen. Die Schnittstellen 110, 210, 220 und 320 sind vorzugsweise als serielle Schnittstellen für eine serielle Datenübertragung ausgebildet. Dementsprechend sind die Schnittstelle 210 des Moduls 200 und die zweite Schnittstelle 120 der Bedieneinheit 100 vorzugsweise als 12-polige Buchse und die erste Schnittstelle 110 der Bedieneinheit 100 und die Schnittstelle 320 des PC 300 vorzugsweise als 12-poliger Stecker ausgebildet, wobei die Schnittstelle 320 in der dargestellten Ausführungsform zusammen mit dem Kabel 325 ein mehrpoliges Anschlusskabel bilden.

Um eine Kommunikation sowohl zwischen Bedieneinheit 100 und Modul 200 als auch zwischen PC 300 und Modul 200 zu realisieren, verfügt die Bedieneinheit 100 über einen Master- und über einen Slave-Protokoll-Stack. Die Bedieneinheit 100 verhält sich dabei gegenüber dem PC 300 wie ein angeschlossener Slave und stellt gegenüber dem Modul 200 einen angeschlossenen Master dar.

Die als serieller Port ausgebildete Kommunikationsschnittstelle 210 der Module 200 hat im dargestellten Ausführungsbeispiel im Protokoll die Adresse 192, der frontseitige serielle Port 120 der Bedieneinheit 100 hingegen die Adresse 191. Im Slave-Stack der Bedieneinheit 100 wird nun als erstes überprüft, welche Adresse das ankommende Telegramm hat. Bei Adresse 191 wird das Telegramm im Slave-Stack der Bedieneinheit 100 abgearbeitet. So ist es möglich, direkt von dem als PC ausgebildeten separaten Bediengerät 300 aus mit der Bedieneinheit 100 zu kommunizieren, um zum Beispiel Parameter zu lesen und/oder zu schreiben. Bei Adresse 192 wird das Telegramm an den Master-Stack der Bedieneinheit 100 weitergegeben und an das angeschlossene Modul 200 gesendet. Die Antwort des Moduls 200 wird anschließend an den PC 300 weitergeleitet.

Da parallel auch eine Kommunikation zwischen Bedieneinheit 100 und Modul 200 stattfinden kann, muss der Slave-Stack der Bedieneinheit 100 - sobald der PC 300 mit dem Modul 200 kommunizieren will - mit der Übergabe des Telegramms an den Master-Stack so lange warten, bis der aktuelle Datentransfer zwischen Bedieneinheit 100 und Modul 200 abgeschlossen ist. Wenn die Firmware der Bedieneinheit 100 mit dem Modul 200 kommunizieren will und gerade ein Datentransfer zwischen PC 300 und Modul 200 stattfindet, muss diese mit dem Beginn des Datentransfers ebenfalls so lange warten, bis die aktuelle Kommunikation zwischen PC 300 und Modul 200 beendet ist.

## Patentansprüche

1. Bedieneinheit (100) zum Bedienen eines insbesondere als Gerät eines Automatisierungssystems ausgebildeten Moduls (200) mit einer modulseitigen Kommunikationsschnittstelle (210), umfassend
- Befestigungsmittel (181, 182) zum lösbaren Befestigen der Bedieneinheit (100) an dem Modul (200), wobei das Befestigungsmittel (181, 182) zum Befestigen der Bedieneinheit (100) an Modulen unterschiedlicher Modultypen ausgebildet ist,
- Eingabe- (130) und Ausgabemittel (140, 142) zum Eingeben und Ausgeben von Informationen,
- eine erste Kommunikationsschnittstelle (110), welche bei befestigter Bedieneinheit (100) mit der modulseitigen Kommunikationsschnittstelle (210) verbunden und zum Datenaustausch zwischen Bedieneinheit (100) und Modul (200) ausgebildet ist, wobei die Bedieneinheit (100) dazu ausgebildet ist, von einem an der ersten Kommunikationsschnittstelle (110) angeschlossenen Modul (200) eine Identifikationsinformation, welche einen Modultyp identifiziert, zu empfangen und zu speichern,
- einen Mikrocontroller, der sich zur Laufzeit selbst programmieren kann,
- wenigstens einen Speicher (152, 154, 162, 164) zum Speichern einer Bedienapplikation mit einem ersten und einem zweiten Applikationsteil, wobei der Speicher einen ersten Speicherbereich (152), in dem der erste Applikationsteil gespeichert ist, und einen zweiten Speicherbereich (162) zum Speichern des zweiten Applikationsteils umfasst, wobei Zugriffe zwischen den Applikationsteilen über eine vorgegebene Schnittstelle (170) erfolgen, und wobei die Bedieneinheit (100) dazu ausgebildet ist, den zweiten Applikationsteil von einem angeschlossenen Modul (200) zu laden und in dem zweiten Speicherbereich zu speichern, wobei die Bedieneinheit (100) dazu ausgebildet ist, vor Herunterladen und Speichern des zweiten Applikationsteils die Identifikationsinformation von dem angeschlossenen Modul (200) zu empfangen und mit der zuletzt gespeicherten Identifikationsinformation zu vergleichen, und nur wenn sich die empfangene und die zuletzt gespeicherte Identifikationsinformation unterscheiden, den zweiten Applikationsteil von dem angeschlossenen Modul (200) zu laden und die empfangene Identifikationsinformation zu speichern,
- eine zweite Kommunikationsschnittstelle (120) zur Kommunikation mit einem separaten Bediengerät (300).

2. Bedieneinheit nach Anspruch 1, wobei das Modul (200) als Gerät der Mess-, Steuer- und Regelungstechnik oder als Konverter für die Mess-, Steuer- und Regelungstechnik ausgebildet ist.

3. Bedieneinheit nach einem der vorstehenden Ansprüche, ausgebildet zur Steuerung einer Kommunikation zwischen einem an der ersten Kommunikationsschnittstelle (110) angeschlossenen Modul (200) und einem an der zweiten Kommunikationsschnittstelle (120) angeschlossenen separaten Bediengerät (300).

4. Bedieneinheit nach Anspruch 3, wobei der modulseitigen Kommunikationsschnittstelle (210) des angeschlossenen Moduls (200) eine erste Adresse und der zweiten Kommunikationsschnittstelle (120) der Bedieneinheit (100) eine zweite, von der ersten unterschiedliche, Adresse zugeordnet sind, und wobei die Bedieneinheit (100) dazu ausgebildet ist, von dem separaten Bediengerät (300) empfangene Datentelegramme, welche die erste Adresse umfassen, an das Modul (200) weiterzuleiten.

5. Bedieneinheit nach Anspruch 4, umfassend einen Master Protokoll-Stack zur Kommunikation mit dem Modul (200) und einen Slave-Protokoll-Stack zur Kommunikation mit dem separaten Bediengerät (300).

6. Bedieneinheit nach einem der vorstehenden Ansprüche, wobei der Speicher einen RAM- (154, 164) und/oder einen Flash-Speicher (152, 162) umfasst.

7. Bedieneinheit nach einem der vorstehenden Ansprüche, wobei das Bedienen des Moduls (200) das Anzeigen und/oder Ändern von Parametrierungs- und/oder Konfigurationsdaten und/oder das Anzeigen von Prozesswerten umfasst.

8. Bedieneinheit nach einem der vorstehenden Ansprüche, wobei die erste (110) und/oder die zweite (120) Kommunikationsschnittstelle für eine serielle Datenübertragung, ausgebildet sind.

9. Verfahren zum Bedienen eines insbesondere als Gerät eines Automatisierungssystems ausgebildeten Moduls (200) mit einer modulseitigen Kommunikationsschnittstelle (210), wobei an dem Modul (200) eine Bedieneinheit (100) nach einem der vorstehenden Ansprüche befestigt wird, so dass die erste Kommunikationsschnittstelle (110) der Bedieneinheit (100) mit der modulseitigen Kommunikationsschnittstelle (210) verbunden ist, und wobei mittels einer in einem Speicher der Bedieneinheit (100) hinterlegten Bedienapplikation eine Benutzerschnittstelle bereitstellt wird, umfassend die Schritte:
- Auslesen einer Identifikationsinformation, welche einen Modultyp identifiziert, aus dem Modul (200) von der Bedieneinheit (100),
- Vergleichen der empfangenen Identifikationsinformation mit einer an einem vorgegebenen Speicherort in der Bedieneinheit (100) hinterlegten Identifikationsinformation durch die Bedieneinheit (100),
wenn sich die empfangene Identifikationsinformation von der hinterlegten Identifikationsinformation unterscheidet,
- Herunterladen eines zweiten Applikationsteils von dem Modul (200) durch die Bedieneinheit (100) und Speichern des heruntergeladenen zweiten Applikationsteils in einem zweiten Speicherbereich (162) der Bedieneinheit (100), wobei der zweite Applikationsteil und ein erster, in einem ersten Speicherbereich (152) der Bedieneinheit hinterlegter erster Applikationsteil die Bedienapplikation bilden, und
- Speichern der empfangenen Identifikationsinformation an dem vorgegebenen Speicherort in der Bedieneinheit (100), und
- Ausführen der Bedienapplikation durch die Bedieneinheit (100), wobei Zugriffe zwischen dem ersten und zweiten Applikationsteil über eine vorgegebene Software-Schnittstelle (170) erfolgen.

10. Verfahren nach Anspruch 9, wobei
- der modulseitigen Kommunikationsschnittstelle (210) des Moduls (200) eine erste Adresse und der zweiten Kommunikationsschnittstelle (120) der Bedieneinheit (100) eine zweite, von der ersten unterschiedliche, Adresse zugeordnet werden, und
- die Bedieneinheit (100) eine Kommunikation zwischen einem an der ersten Kommunikationsschnittstelle (110) angeschlossenen Modul und einem an der zweiten Kommunikationsschnittstelle (120) angeschlossenen separaten Bediengerät (300) steuert, wobei an die erste Adresse adressierte Datentelegramme, welche die Bedieneinheit (100) von einem an der zweiten Kommunikationsschnittstelle (120) angeschlossenen separaten Bediengerät (300) empfängt, an das Modul (200) weitergeleitet werden.

11. Verfahren nach Anspruch 10, wobei bei Empfang eines an die erste Adresse adressierten Datentelegramms von dem separaten Bediengerät (300) und gleichzeitiger Kommunikation zwischen Bedieneinheit (100) und Modul (200) das Weiterleiten des von dem separaten Bediengerät (300) empfangenen Datentelegramm an das Modul (200) verzögert wird, bis die Kommunikation zwischen Bedieneinheit (100) und Modul (200) abgeschlossen ist, und wobei bei gleichzeitiger Kommunikation zwischen separatem Bediengerät (300) und Modul (200) eine durch die Bedieneinheit (100) initiierte Kommunikation zwischen Bedieneinheit (100) und Modul (200) verzögert wird, bis die Kommunikation zwischen separatem Bediengerät (300) und Modul (200) abgeschlossen ist.

## Claims

1. An operating unit (100) for operating a module (200), which is designed in particular as a device in an automation system and has a module-side communication interface (210), comprising
- fastening means (181, 182) for detachably fastening the operating unit (100) to the module (200), wherein the fastening means (181, 182) are designed for fastening the operating unit (100) onto modules of different types of modules,
- input (130) and output means (140, 142) for input and output of information,
- a first communication interface (110), which is connected to the module-side communication interface (210) when the operating unit (100) is fastened and is designed for data exchange between the operating unit (100) and the module (200), wherein the operating unit (100) is designed to receive and store identification information which identifies a type of module from a module (200) connected to the first communication interface (110),
- a microcontroller which can program itself during run time,
- at least one memory (152, 154, 162, 164) for storing an operating application with a first and a second application part, wherein the memory comprises a first memory area (152) in which the first application part is stored and a second memory area (162) for storing the second application part, wherein accesses between the application parts are carried out via a predefined interface (170), and wherein the operating unit (100) is designed to load the second application part from a connected module (200) and store it in the second memory area, wherein the operating unit is designed to receive the identification information from the connected module (200) before downloading and storing the second application part and to compare this information with the identification information stored last and to load the second application part from the connected module (200) and save the received identification information only if the received identification information and the identification information stored last are different,
- a second communication interface (120) for communication with a separate operating device (300).

2. The operating unit according to claim 1, wherein the module (200) is designed as a device of the measurement, control and regulating technology or as a converter for the measurement, control and regulating technology.

3. The operating unit according to any one of the preceding claims designed for control of a communication between a module (200) that is connected to the first communication interface (110) and a separate operating device (300) that is connected to the second communication interface (120).

4. The operating unit according to claim 3, wherein a first address is assigned to the module-side communication interface (210) of the connected module (200), and a second address, which is different from the first address, is assigned to the second communication interface (120) of the operating unit (100), and wherein the operating unit (100) is designed to relay data telegrams which include the first address and are received from the separate operating device (300) to the module (200).

5. The operating unit according to claim 4, comprising a master protocol stack for communication with the module (200) and a slave protocol stack for communication with the separate operating device (300).

6. The operating unit according to any one of the preceding claims, wherein the memory comprises a RAM memory (154, 164) and/or a flash memory (152, 162).

7. The operating unit according to any one of the preceding claims, wherein the operation of the module (200) comprises the display and/or alteration of parameterization data and/or configuration data and/or the display of process values.

8. The operating unit according to any one of the preceding claims, wherein the first communication interface (110) and/or the second communication interface (120) is/are designed for a serial data transmission.

9. A method for operating a module (200) designed in particular as a device in an automation system and having a module-side communication interface (210), wherein an operating unit (100) according to any one of the preceding claims is attached to the module (200) so that the first communication interface (110) of the operating unit (100) is connected to the module-side communication interface (210), and wherein a user interface is provided by means of an operating application stored in a memory of the operating unit (100), comprising the following steps:
- readout of an identification information which identifies a module type from the module (200) by the operating unit (100),
- comparison by the operating unit (100) of the received identification information with identification information stored at a predefined memory location in the operating unit (100),
when the received identification information differs from the stored identification information,
- downloading a second application part from the module (200) by the operating unit (100) and saving the downloaded second application part in a second memory area (162) of the operating unit (100), wherein the second application part and a first application part stored in a first memory area (152) of the operating unit form the operating application, and
- storing the received identification information at the predefined memory location in the operating unit (100), and
- executing the operating application by the operating unit (100), wherein accesses between the first and second application part are carried out via a predefined software interface (170).

10. The method according to claim 9, wherein
- a first address is assigned to the module-side communication interface (210) of the module (200) and a second address, which is different from the first address, is assigned to the second communication interface (120) of the operating unit (100), and
- the operating unit (100) controls a communication between a module connected to the first communication interface (110) and a separate operating device (300) connected to the second communication interface (120), wherein data telegrams, which are addressed to the first address and are received by the operating unit (100) from a separate operating device (300) connected to the second communication interface (120) are relayed to the module (200).

11. The method according to claim 10, wherein when a data telegram addressed to the first address is received from the separate operating device (300) and at the same time there is communication between the operating unit (100) and the module (200), the relay of the data telegram received from the separate operating device (300) to the module (200) is delayed until the communication between the operating unit (100) and the module (200) is concluded, and wherein when there is simultaneous communication between the separate operating device (300) and the module (200), a communication initiated by the operating unit (100) between the operating unit (100) and the module (200) is delayed until the communication between the separate operating device (300) and the module (200) is concluded.

## Revendications

1. Unité de commande (100) destinée à la commande d'un module (200) prévu en particulier comme appareil d'un système d'automatisation avec une interface de communication (210) côté module, comprenant :
- des moyens de fixation (181, 182) pour la fixation amovible de l'unité de commande (100) sur le module (200), les moyens de fixation (181, 182) étant prévus pour la fixation de l'unité de commande (100) sur des modules de types différents,
- des moyens d'entrée (130) et de sortie (140, 142) pour la saisie et l'émission d'informations,
- une première interface de communication (110), laquelle est reliée à l'interface de communication (210) côté module lorsque l'unité de commande (100) est fixée et est prévue pour une communication de données entre l'unité de commande (100) et le module (200), l'unité de commande (100) étant prévue pour recevoir d'un module (200) relié à la première interface de communication (110) une information d'identification identifiant un type de module, et mémoriser celle-ci,
- un microcontrôleur apte à s'autoprogrammer relativement au temps d'exécution,
- au moins une mémoire (152, 154, 162, 164) pour le stockage d'une application de commande avec une première et une deuxième partie d'application, ladite mémoire comprenant une première zone de mémoire (152) où est stockée la première partie d'application, et une deuxième zone de mémoire (162) pour le stockage de la deuxième partie d'application, les accès entre les parties d'application ayant lieu via une interface (170) définie, et l'unité de commande (100) étant prévue pour charger la deuxième partie d'application depuis un module (200) raccordé et mémoriser celle-ci dans une deuxième zone de mémoire, l'unité de commande (100) étant prévue pour recevoir l'information d'identification du module (200) raccordé avant téléchargement et stockage de la deuxième partie d'application et comparer celle-ci avec la dernière information d'identification mémorisée, et charger la deuxième partie d'application depuis le module (200) raccordé et mémoriser l'information d'identification reçue seulement si l'information d'identification reçue et la dernière information d'identification mémorisée sont distinctes,
- une deuxième interface de communication (120) pour la communication avec un appareil de commande (300) séparé.

2. Unité de commande selon la revendication 1, où le module (200) est réalisé comme appareil de mesure, de commande et de régulation ou comme convertisseur de mesure, de commande et de régulation.

3. Unité de commande selon l'une des revendications précédentes, réalisée comme commande de communication entre un module (200) relié à la première interface de communication (110) et un appareil de commande (300) séparé relié à la deuxième interface de communication (120).

4. Unité de commande selon la revendication 3, où une première adresse est affectée à l'interface de communication (210) côté module du module (200) raccordé et une deuxième adresse distincte de la première adresse est affectée à la deuxième interface de communication (120) de l'unité de commande (100), et où l'unité de commande (100) est prévue pour transmettre au module (200) des télégrammes de données reçus de l'appareil de commande (300) séparé et qui contiennent la première adresse.

5. Unité de commande selon la revendication 4, comprenant une pile de protocole maître pour la communication avec le module (200) et une pile de protocole esclave pour la communication avec l'appareil de commande (300) séparé.

6. Unité de commande selon l'une des revendications précédentes, dans laquelle la mémoire comprend une mémoire RAM (154, 164) et/ou une mémoire Flash (152, 162).

7. Unité de commande selon l'une des revendications précédentes, où la commande du module (200) comprend l'affichage et/ou la modification de données de paramétrage et/ou de données de configuration et/ou l'affichage de valeurs de processus.

8. Unité de commande selon l'une des revendications précédentes, dans laquelle la première (110) et/ou la deuxième (120) interfaces de communication sont prévues pour une transmission de données en série.

9. Procédé de commande d'un module (200) prévu en particulier comme appareil d'un système d'automatisation avec une interface de communication (210) côté module, une unité de commande (100) selon l'une des revendications précédentes étant fixée sur le module (200), de manière à relier la première interface de communication (110) de l'unité de commande (100) à l'interface de communication (210) côté module, et une interface d'utilisateur étant réalisée au moyen d'une application de commande stockée dans une mémoire de l'unité de commande (100), comprenant les étapes suivantes :
- lecture d'une information d'identification identifiant un type de module, du module (200) de l'unité de commande (100),
- comparaison par l'unité de commande (100) de l'information d'identification reçue à une information d'identification mémorisée dans un emplacement de mémoire défini dans l'unité de commande (100),
si l'information d'identification reçue se distingue de l'information d'identification mémorisée,
- téléchargement d'une deuxième partie d'application du module (200) par l'unité de commande (100) et stockage de la deuxième partie d'application téléchargée dans une deuxième zone de mémoire (162) de l'unité de commande (100), la deuxième partie d'application et une première partie d'application stockée dans une première zone de mémoire (152) de l'unité de commande formant l'application de commande, et
- mémorisation de l'information d'identification reçue à l'emplacement de mémoire défini dans l'unité de commande (100), et
- exécution de l'application de commande par l'unité de commande (100), des accès entre les première et deuxième parties d'application ayant lieu via une interface logicielle (170) définie.

10. Procédé selon la revendication 9, dans lequel :
- une première adresse est affectée à l'interface de communication (210) côté module du module (200) et une deuxième adresse distincte de la première adresse est affectée à la deuxième interface de communication (120) de l'unité de commande (100), et
- l'unité de commande (100) commande une communication entre un module relié à la première interface de communication (110) et un appareil de commande (300) séparé relié à la deuxième interface de communication (120), des télégrammes de données envoyés vers la première adresse, que l'unité de commande (100) reçoit d'un appareil de commande (300) séparé relié à la deuxième interface de communication (120), étant transmis au module (200).

11. Procédé selon la revendication 10, dans lequel, en cas de réception d'un télégramme de données envoyé vers la première adresse par l'appareil de commande (300) séparé et de communication simultanée entre l'unité de commande (100) et le module (200), la transmission au module (200) du télégramme de données reçu de l'appareil de commande (300) séparé est retardée jusqu'à ce que la communication entre l'unité de commande (100) et le module (200) soit terminée, et dans lequel, en cas de communication simultanée entre l'appareil de commande (300) séparé et le module (200), une communication initiée par l'unité de commande (100) entre l'unité de commande (100) et le module (200) est retardée jusqu'à ce que la communication entre l'appareil de commande (300) séparé et le module (200) soit terminée.
